# EUROPÄISCHE PATENTANMELDUNG

(11) **EP 3 735 117 A1**
(43) Veröffentlichungstag der Anmeldung: **04.11.2020**
(21) Anmeldenummer: 19172580.3
(22) Anmeldetag: 03.05.2019
(51) Int. Cl.: H05K 7/20

(54) **KÜHLUNG VON SERIELL IN EINEM KÜHLMITTELSTROM ANGEORDNETEN WÄRMEQUELLEN**

(71) Anmelder: Siemens Aktiengesellschaft, 80333 München (DE)
(72) Erfinder: Erlebach, Mario, 09112 Chemnitz (DE); Hentschel, Andreas, 04425 Taucha (DE); Wolf, Friedrich, 09112 Chemnitz (DE)

(57) **Zusammenfassung**

Die Erfindung betrifft eine Kühlanordnung (1) aufweisend eine erste Wärmequelle (11) und eine zweite Wärmequelle (12), sowie einen Kühlkörper (2) zum Übertragen von Wärme an ein an einer ersten Oberfläche (21) und an einer zweiten Oberfläche (22) des Kühlkörpers vorbeistreifendes Kühlmedium (3), wobei die erste Wärmequelle und die zweite Wärmequelle (12) derart am Kühlkörper angeordnet sind, dass von der zweiten Wärmequelle (12) Wärme an das von der ersten Wärmequelle (11) vorerwärmte Kühlmedium (3) übertragbar ist. Zur Verbesserung der Kühlanordnung wird vorgeschlagen dass die erste Oberfläche (21) kleiner ist als die zweite Oberfläche (22), wobei die erste Oberfläche (21) einer für den Wärmeübergang zwischen erster Wärmequelle (11) und Kühlmedium (3) relevanten Fläche entspricht, wobei die zweite Oberfläche (22) einer für den Wärmeübergang zwischen zweiter Wärmequelle (12) und Kühlmedium (3) relevanten weiteren Fläche entspricht.

## Beschreibung

Die Erfindung betrifft eine Kühlanordnung aufweisend eine erste Wärmequelle und eine zweite Wärmequelle, sowie einen Kühlkörper zum Übertragen von Wärme an ein an einer ersten Oberfläche und an einer zweiten Oberfläche des Kühlkörpers vorbeistreifendes Kühlmedium, wobei die erste Wärmequelle und die zweite Wärmequelle derart am Kühlkörper angeordnet sind, dass von der zweiten Wärmequelle Wärme an das von der ersten Wärmequelle vorerwärmte Kühlmedium übertragbar ist.

Durch konstruktive Zwänge werden Wärmequellen (z.B. elektronische Bauelemente) oftmals seriell im Kühlmittelstrom angeordnet. Das Kühlmedium wird dabei bereits von der ersten Wärmequelle erwärmt. Somit erreicht das Kühlmedium die nachfolgende Wärmequelle bereits mit einer höheren Temperatur. Die nachfolgende Wärmequelle wird weniger gut gekühlt und hat damit eine höhere Temperatur. Dies kann sich negativ auf die Lebensdauer der nachfolgenden Wärmequelle auswirken.

Um diese unerwünschte Vorerwärmung und die damit verbundene reduzierte Lebensdauer zu vermeiden werden oftmals alle Wärmequellen einzeln gekühlt. Dabei sind die Wärmequellen parallel in einem Kühlmittelstrom angeordnet.

Der Erfindung liegt die Aufgabe zugrunde eine Kühlanordnung mit mehreren Wärmequellen zu verbessern.

Diese Aufgabe wird durch eine Kühlanordnung aufweisend eine erste Wärmequelle und eine zweite Wärmequelle, sowie einen Kühlkörper zum Übertragen von Wärme an ein an einer ersten Oberfläche und an einer zweiten Oberfläche des Kühlkörpers vorbeistreifendes Kühlmedium gelöst, wobei die erste Wärmequelle und die zweite Wärmequelle derart am Kühlkörper angeordnet sind, dass von der zweiten Wärmequelle Wärme an das von der ersten Wärmequelle vorerwärmte Kühlmedium übertragbar ist, wobei die erste Oberfläche kleiner ist als die zweite Oberfläche, wobei die erste Oberfläche einer für den Wärmeübergang zwischen erster Wärmequelle und Kühlmedium relevanten Fläche entspricht, wobei die zweite Oberfläche einer für den Wärmeübergang zwischen zweiter Wärmequelle und Kühlmedium relevanten weiteren Fläche entspricht.

Vorteilhafte Ausgestaltungen der Erfindung sind in den abhängigen Ansprüchen angegeben.

Der Erfindung liegt die Erkenntnis zugrunde, dass sich die Kühlung, auch als Entwärmung bezeichnet, der zweiten Wärmequelle an ein von einer ersten Wärmequelle bereits vorerwärmtes Kühlmedium dadurch verbessern lässt, dass die zweite Oberfläche größer ist als die erste Oberfläche. Dabei sind die erste Oberfläche und die zweite Oberfläche jeweils Flächen am Kühlkörper, an denen das Kühlmedium vorbeiströmt. Dabei strömt das Kühlmedium zuerst an der ersten Oberfläche vorbei und nimmt Wärme auf. Dadurch steigt die Temperatur des Kühlmediums bevor es die zweite Oberfläche erreicht.

Bei dem Kühlkörper kann es sich um einen Kühlkörper für ein gasförmiges Kühlmedium handeln. Dann kann der Kühlkörper an der ersten wie auch zweiten Oberfläche offen gegenüber der Umgebung ausgeführt sein. Ebenso kann der Kühlkörper auch zur Kühlung mit einem flüssigen Kühlmedium ausgebildet sein. Dann ist die erste und die zweite Oberfläche Teil eines Kühlkanals, der das Kühlmedium führt. Ebenso ist es möglich, einen solchen Kühlkanal auch für eine Kühlung mit gasförmigem Kühlmedium vorzusehen.

Die erste Oberfläche bildet dabei die für den Wärmeübergang von der ersten Wärmequelle an das Kühlmedium relevante Fläche. Dabei handelt es sich um die Fläche, die sich beim Betrieb der ersten Wärmequelle erwärmt. Die erste Oberfläche bildet dabei den Bereich, in dem ein Großteil der Wärme der ersten Wärmequelle an das Kühlmedium übertragen wird. Entsprechendes gilt für die zweite Oberfläche und die zweite Wärmequelle.

Die erste und die zweite Oberfläche umfasst oftmals Pins oder Kühlrippen, um die für den Wärmeübergang wirksame Fläche der entsprechenden Oberfläche zu erhöhen.

Die relevante Fläche kann als Teil der für den Wärmeübergang wirksamen Fläche definiert werden. Um eine Vergleichbarkeit der ersten und der zweiten Oberfläche zu ermöglichen, ist es hinreichend, wenn die erste Oberfläche bzw. die zweite Oberfläche jeweils den gleichen Anteil der wirksamen Oberfläche darstellen. Beispielsweise kann die erste bzw. zweite Oberfläche dadurch charakterisiert sein, dass an ihr 2/3, 90%, 95% oder sogar noch mehr der Wärme der entsprechenden Wärmequelle an das Kühlmedium übertragen wird. Für die wirksame Fläche gibt es keine scharfen Grenzen, da die Temperatur im Kühlkörper und damit der Wärmeübergang an der Oberfläche des Kühlkörpers sich kontinuierlich über den Kühlkörper verändert, wobei der Wärmeübertrag an das Kühlmedium mit steigendem Abstand zur Wärmequelle stark nachlässt.

Die größere Fläche der zweiten Oberfläche im Vergleich zur ersten Oberfläche bewirkt, dass auch bei höherer Temperatur des Kühlmediums im Bereich der zweiten Oberfläche ein entsprechender Wärmeübergang bei geringerer Temperaturdifferenz zwischen der zweiten Oberfläche und dem dortigen Kühlmedium erfolgen kann. Damit kann die Temperatur an der zweiten Wärmequelle reduziert werden. Für einen entsprechenden Wärmeübergang ist aufgrund der größeren Fläche der zweiten Oberfläche eine geringere Temperaturdifferenz zwischen Kühlkörper und Kühlmedium notwendig. Damit wird der Wärmeübergang im Bereich der zweiten Oberfläche derart verbessert, dass sich trotz höherer Temperatur des Kühlmediums je nach Auslegung der ersten und zweiten Oberfläche sich die Temperatur in der Umgebung der zweiten Wärmequelle reduzieren lässt. Beispielsweise kann durch die größere zweite Oberfläche die Kühlanordnung derart ausgelegt werden, dass die gleiche vorgebbare Wärmemenge bei den beiden Wärmequellen an das Kühlmedium übertragen werden, wobei die Temperaturen an der ersten und der zweiten Oberfläche und damit auch an den beiden Wärmequellen gleich sind.

Durch diese Kühlanordnung ergibt sich eine Leistungssteigerung, da die Geräte, die eine Wärmequelle darstellen, gleichmäßiger entwärmt werden. Darüber hinaus ergibt sich auch eine Lebensdauersteigerung bzw. eine Angleichung der Lebensdauer der Geräte, die eine Wärmequelle darstellen, da aufgrund der Angleichung der Betriebstemperaturen der Geräte die Lebensdauer sich nicht mehr signifikant verkürzt.

Diese Anordnung lässt sich auch um eine oder mehrere Wärmequellen erweitern. Je stärker das Kühlmedium durch im Kühlkreis zuvor eingebrachte Wärme vorerwärmt wird, desto größer wird die für den Wärmeübergang relevante Fläche einer entsprechenden weiteren Oberfläche ausgelegt. Dabei entspricht die weitere Oberfläche einer für den Wärmeübergang zwischen weiterer Wärmequelle und Kühlmedium relevanten noch weiteren Fläche.

Bei einer vorteilhaften Ausgestaltung der Erfindung ist die Anzahl von Pins und/oder Kühlrippen im Bereich der ersten Oberfläche kleiner als im Bereich der zweiten Oberfläche. Eine einfache und kostengünstige Möglichkeit die Fläche der zweiten Oberfläche gegenüber der Fläche der ersten Oberfläche zu erhöhen, besteht darin, die Anzahl der Pins und/oder Kühlrippen zu erhöhen. Bei gleicher oder zumindest ähnlicher Größe der Pins und/oder Kühlrippen wird damit die relevante Fläche der zweiten Oberfläche erhöht. Damit kann der Wärmeübergang im Bereich der zweiten Oberfläche derart verbessert werden, dass sich trotz höherer Temperatur des Kühlmediums sich keine höheren Temperaturen am Kühlkörper im Bereich der zweiten Wärmequelle einstellen.

Bei einer weiteren vorteilhaften Ausgestaltung der Erfindung ist die Größe von Pins und/oder Kühlrippen oder zumindest eines Teils der Pins und/oder Kühlrippen im Bereich der ersten Oberfläche kleiner als im Bereich der zweiten Oberfläche. Unabhängig von der Anzahl der Pins und/oder Kühlrippen lässt sich die Fläche der zweiten Oberfläche gegenüber der Fläche der ersten Oberfläche dadurch erhöhen, dass größere Pins bzw. Kühlrippen diese Oberfläche bilden. Dadurch kann die Temperatur im Bereich der zweiten Wärmequelle noch weiter reduziert bzw. eine noch höhere Vorerwärmung durch die erste Wärmequelle toleriert werden.

Im Folgenden wird die Erfindung anhand des in der FIG dargestellten Ausführungsbeispiels näher beschrieben und erläutert. Es zeigt:
FIG eine Kühlanordnung mit unterschiedlich vielen Pins.

Die FIG zeigt eine Kühlanordnung 1 mit einem Kühlkörper 2. Auf diesem Kühlkörper 2 sind rückseitig, gestrichelt angedeutet, eine erste Wärmequelle 11 und eine zweite Wärmequelle 12 angeordnet. Auf der Vorderseite strömt das Kühlmedium 3 an dem Kühlkörper 2 entlang. Die Strömung des Kühlmediums 3 kann dabei, wie in diesem Ausführungsbeispiel, in einem Kühlkanal erfolgen oder auch alternativ offen ausgebildet sein, wie es sich insbesondere für ein gasförmiges Kühlmedium anbietet. Der Kühlkanal ist hier offen dargestellt, um einen Blick auf eine erste Oberfläche 21 und eine zweite Oberfläche 22 zu haben. An diesen beiden Oberflächen erfolgt im Wesentlichen der Wärmeübergang von den jeweiligen Wärmequellen 11, 12 an das Kühlmedium 3. Somit stellen die erste und die zweite Oberfläche 21,22 die für den Wärmeübergang relevanten Oberflächen dar. Der Bereich, über den sich die erste Oberfläche 21 erstreckt entspricht in etwa dem Bereich, in dem die erste Wärmequelle 11 rückseitig montiert ist. Damit erstreckt sich die erste Oberfläche in etwa über den gestrichelt dargestellten Bereich. Entsprechendes gilt für die zweite Oberfläche 22 und die zweite Wärmequelle 12. Die erste Oberfläche 21 wird dabei mit einer geringeren Anzahl an Pins 23 gebildet, während die zweite Oberfläche 22 eine höhere Anzahl an Pins 23 aufweist. Zudem können, allerdings nicht notwendigerweise, die einzelnen Pins 23 der zweiten Oberfläche 22 noch eine größere Ausdehnung in Richtung aus der Zeichenebene hinaus besitzen, so dass sie auch größer sind als die Pins der ersten Oberfläche 21.

Die Bewegungsrichtung des Kühlmediums 3 ist mit Pfeilen gekennzeichnet. Fließt nun das Kühlmedium 3 an der ersten Oberfläche 21 entlang, so nimmt es Wärme aufgrund der Verlustleistung von der ersten Wärmequelle 11 auf. Dadurch erwärmt sich das Kühlmedium 3. Das nun vorerwärmte Kühlmedium 3 fließt dann an der zweiten Oberfläche 22 entlang. Dadurch, dass die zweite Oberfläche 22 größer ist als die erste Oberfläche 21 kann auch bei geringerer Temperaturdifferenz zwischen zweiter Oberfläche 22 und Kühlmedium 3 im Vergleich zur Temperaturdifferenz zwischen erster Oberfläche 21 und Kühlmedium 3 die gleiche oder sogar je nach Auslegung eine höhere Wärmemenge von der zweiten Wärmequelle 12 an das Kühlmedium 3 übertragen werden. Die Kühlung lässt sich damit über das Verhältnis der Oberflächen zueinander auf den entsprechenden Anwendungsfall derart optimieren, dass im Betrieb an den Wärmequellen die gleichen Temperaturen entstehen. Mit anderen Worten kann durch die Gestaltung der Oberflächen 21,22 ein Nachteil durch ein bereits vorerwärmtes Kühlmedium beseitigt werden.

Ein weiterer Vorteil dieser Anordnung besteht darin, dass zusätzlich über den möglicherweise größeren freien Strömungsquerschnitt im Bereich der ersten Oberfläche 21 im Vergleich zur zweiten Oberfläche 22 ein geringerer Gegendruck erzeugt wird, der zu einem höheren Gesamtvolumenstrom des Kühlmediums bei sonst gleichen Randbedingungen genutzt werden kann.

Zusammenfassend betrifft die Erfindung eine Kühlanordnung aufweisend eine erste Wärmequelle und eine zweite Wärmequelle, sowie einen Kühlkörper zum Übertragen von Wärme an ein an einer ersten Oberfläche und an einer zweiten Oberfläche des Kühlkörpers vorbeistreifendes Kühlmedium, wobei die erste Wärmequelle und die zweite Wärmequelle derart am Kühlkörper angeordnet sind, dass von der zweiten Wärmequelle Wärme an das von der ersten Wärmequelle vorerwärmte Kühlmedium übertragbar ist. Zur Verbesserung der Kühlanordnung wird vorgeschlagen dass die erste Oberfläche kleiner ist als die zweite Oberfläche, wobei die erste Oberfläche einer für den Wärmeübergang zwischen erster Wärmequelle und Kühlmedium relevanten Fläche entspricht, wobei die zweite Oberfläche einer für den Wärmeübergang zwischen zweiter Wärmequelle und Kühlmedium relevanten weiteren Fläche entspricht.

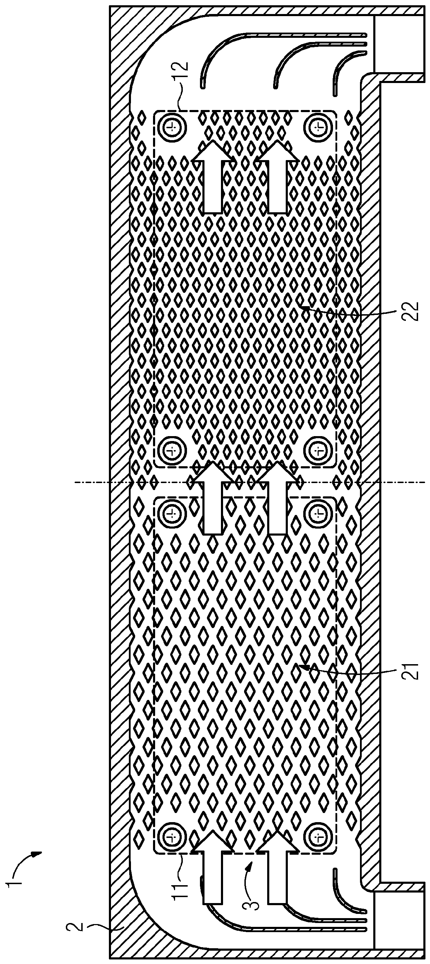

## Patentansprüche

1. Kühlanordnung (1) aufweisend
- eine erste Wärmequelle (11) und eine zweite Wärmequelle (12)
- einen Kühlkörper (2) zum Übertragen von Wärme an ein an einer ersten Oberfläche (21) und an einer zweiten Oberfläche (22) des Kühlkörpers vorbeistreifendes Kühlmedium (3), wobei die erste Wärmequelle (11) und die zweite Wärmequelle (12) derart am Kühlkörper (2) angeordnet sind, dass von der zweiten Wärmequelle (12) Wärme an das von der ersten Wärmequelle (11) vorerwärmte Kühlmedium (3) übertragbar ist,
**dadurch gekennzeichnet, dass** die erste Oberfläche (21) kleiner ist als die zweite Oberfläche (22), wobei die erste Oberfläche (21) einer für den Wärmeübergang zwischen erster Wärmequelle (11) und Kühlmedium (3) relevanten Fläche entspricht, wobei die zweite Oberfläche (22) einer für den Wärmeübergang zwischen zweiter Wärmequelle (12) und Kühlmedium (3) relevanten weiteren Fläche entspricht.

2. Kühlanordnung nach Anspruch 1, wobei die Anzahl von Pins und/oder Kühlrippen im Bereich der ersten Oberfläche (21) kleiner ist als im Bereich der zweiten Oberfläche (22).

3. Kühlanordnung nach einem der Ansprüche 1 oder 2, wobei die Größe von Pins und/oder Kühlrippen oder zumindest eines Teils der Pins und/oder Kühlrippen im Bereich der ersten Oberfläche (21) kleiner ist als im Bereich der zweiten Oberfläche (22).
